# EUROPÄISCHE PATENTSCHRIFT

(11) **EP 3 346 177 B1**
(45) Veröffentlichungstag und Bekanntmachung des Hinweises auf die Patenterteilung: **13.03.2019**
(21) Anmeldenummer: 17150220.6
(22) Anmeldetag: 04.01.2017
(51) Int. Cl.: F16P 3/08, F16P 3/10

(54) **SICHERHEITSEINRICHTUNG**
SAFETY DEVICE
DISPOSITIF DE SÉCURITÉ

(43) Veröffentlichungstag der Anmeldung: 11.07.2018
(73) Patentinhaber: SICK AG, 79183 Waldkirch/Breisgau (DE)
(72) Erfinder: PHAY, Victor Kok Heng, 507072 Singapur (SG); SCHWARZ, Adrian, 79215 Elzach (DE)
(74) Vertreter: Manitz Finsterwald Patentanwälte PartmbB

(56) Entgegenhaltungen:
- WO-A1-03/012998
- DE-A1- 10 252 025
- DE-U1- 20 306 708

## Beschreibung

Die vorliegende Erfindung betrifft eine Sicherheitseinrichtung zum Absichern einer Maschine, gemäß dem Gegenstand des Anspruchs 1.

Bei gefahrbringenden Maschinen sind oftmals Trennvorrichtungen wie Einhausungen, Abdeckungen, Türen, Klappen oder dergleichen vorgesehen, um Personen während des Betriebs an einem Zugang zu Gefahrenbereichen der Maschine zu hindern. Des Weiteren kann es für den Betrieb der Maschine erforderlich sein, dass sich bestimmte sicherheitsrelevante Maschinenteile in einem vorgegebenen sicheren Zustand befinden. Um zu gewährleisten, dass die Trennvorrichtungen während des Betriebs der Maschine tatsächlich geschlossen sind bzw. sich die sicherheitsrelevanten Maschinenteile in ihrem sicheren Zustand befinden, werden Sicherheitseinrichtungen vorgesehen, die ein Ingangsetzen der Maschine nur dann erlauben, wenn die Trennvorrichtungen geschlossen sind bzw. sich in einer sicheren Position befinden bzw. die sicherheitsrelevanten Maschinenteile sich in ihrem sicheren Zustand befinden. Ein Öffnen oder Entfernen der Trennvorrichtungen während des laufenden Betriebs der Maschine führt in der Regel zu einem sofortigen Abschalten der Maschine.

Beispielsweise kann an der Trennvorrichtung ein Aktuator als zu detektierendes Objekt angeordnet sein, das sich nur dann in dem Überwachungsbereich des Sensors befindet und von dem Sensor detektiert wird, wenn sich die zugeordnete Trennvorrichtung in ihrer bestimmungsgemäßen sicheren Position befindet. Ein Öffnen oder Entfernen der Trennvorrichtung führt dazu, dass der Aktuator aus dem Überwachungsbereich entfernt wird und der Sensor somit kein Erfassungssignal mehr ausgibt, was wiederum dazu führt, dass die Auswerteeinheit ein entsprechendes Ausgangssignal ausgibt. Dieses Ausgangssignal kann beispielsweise ein Öffnen eines Sicherheitsschaltkontakts sein. Dieser Sicherheitsschaltkontakt kann durch die Maschine überwacht werden, wobei ein Betrieb der Maschine nur bei geschlossenem Kontakt zulässig ist.

Bei einer derartigen Sicherheitseinrichtung kann beispielsweise ein sogenannter Näherungsschalter, insbesondere ein induktiver Näherungsschalter als Sensor verwendet werden. Ein als induktiver Näherungsschalter ausgebildeter Sensor erzeugt im Überwachungsbereich ein Magnetfeld. Befindet sich ein metallischer, insbesondere ferromagnetischer Gegenstand als Aktuator in diesem Magnetfeld, bewirkt dieser eine Veränderung der magnetischen Feldstärke, welche von dem Sensor detektiert wird und die Ausgabe des Erfassungssignals veranlasst.

Häufig werden herkömmliche Sicherheitseinrichtungen jedoch manipuliert. Um etwa einen Betrieb der Maschine bei entfernter Trennvorrichtung zu ermöglichen, wird anstelle des an der Trennvorrichtung angeordneten Aktuators ein systemfremder Aktuator oder einfach ein anderer metallischer Gegenstand in den Überwachungsbereich des Sensors eingebracht und somit fälschlicherweise ein sicherer Zustand der Maschine vorgetäuscht. Die Gefahr derartiger Manipulationen besteht in entsprechender Weise auch bezüglich des sicheren Zustands von sicherheitsrelevanten Maschinenteilen.

Um solche Manipulationen zu verhindern, können codierte Aktuatoren vorgesehen werden. Ein Beispiel für derartige Systeme sind sogenannte RFID-Systeme (von englisch "radio-frequency identification"), bei denen ein RFID-Transponder als Aktuator und ein RFID-Lesegerät als Sensor eingesetzt werden. Der RFID-Transponder sendet einen kennzeichnenden Code aus, welcher eine Identifizierung des detektierten Objekts bzw. Aktuators ermöglicht und dadurch Manipulationen erschwert. Allerdings können nicht codierte (wie z.B. induktive Sensoren) und auch niedrigcodierte Sicherheitssysteme (wie magnetische Sensoren und RFID Systeme in einer universell codierten Betriebsart) manipuliert werden, da die Anzahl der zur Verfügung stehenden Codevariationen oftmals begrenzt ist und somit Objekte mit gleichem Code (z.B. mit gleichem Muster oder gleichem RFID-Nummernkreis) zur Manipulation verwendet werden. Systeme mit höherem Codierungsniveau sind häufig wesentlich kostspieliger.

Bei allen codierten Sicherheitseinrichtungen ist zudem ein erhöhter Aufwand bei der Neuinstallation oder bei einem Austausch von Sensoren und/oder Aktuatoren erforderlich, da die Codierungen von Sensor und Aktuator aufeinander abgestimmt sein müssen und eine mehrfache Verwendung desselben Codes bei einer jeweiligen Maschine vermieden werden sollte.

DE 203 06 708 U1 betrifft eine Zugangsschutzeinrichtung, mit deren Hilfe eine Zugangsöffnung einer Maschine, die mit einer Tür verschließbar ist, überwacht werden kann. Die Tür kann mittels einer Zuhaltung, die ein magnetisierbares Joch und einen mit dem Joch schließbaren Magneten umfasst, verriegelt werden. Der Schließzustand der Tür wird mit Hilfe eines Magnetfeldsensors überwacht, wobei zusätzlich eine Sensoreinheit vorgesehen ist, die Signale von einem an der Tür angebrachten Antwortsender empfangen kann.

Eine ähnliche Vorrichtung ist in DE 102 52 025 A1 beschrieben. Die Tür wird mit Hilfe eines Schlosses gesichert, welches einen Riegel und eine Zuhaltung zum Arretieren des Riegels in seiner Schließstellung aufweist. Zwei Transponder sind am Riegel bzw. an der Zuhaltung befestigt. Ein Abtastkopf kann nur dann Identifizierungssignale von den beiden Transpondern als Erfassungsignal bzw. als zusätzliches Kriterium empfangen, wenn sich der Riegel in der Schließstellung befindet und durch die Zuhaltung arretiert ist.

Eine weitere gattungsähnliche Vorrichtung ist in der WO 03/012998 A1 offenbart. Hier wird der Schließzustand einer Tür mit Hilfe eines Hallelements überwacht, wobei ein erstes Ausgangssignal in Abhängigkeit von der Anwesenheit eines magnetischen Elements erzeugt wird. Zusätzlich ist ein Fensterkomparator vorgesehen, welcher das Ausgangssignal des Hallelements dahingehend überwacht, ob es sich innerhalb eines vorgegebenen Signalfensters befindet, d.h. ob eine zweite höhere Signalschwelle nicht überschritten wird. Durch dieses zusätzliche Kriterium soll eine Manipulation mit beliebigen Magneten ausgeschlossen werden.

Es ist die Aufgabe der vorliegenden Erfindung, eine Sicherheitseinrichtung der eingangs genannten Art anzugeben, welche bei hoher Manipulationssicherheit kostengünstig herzustellen, zu installieren und zu warten ist.

Die Lösung erfolgt durch eine Sicherheitseinrichtung mit den Merkmalen des Anspruchs 1. Erfindungsgemäß ist vorgesehen, dass die Auswerteeinheit dazu ausgelegt ist, das Ausgangssignal ferner in Abhängigkeit von zumindest einem zusätzlichen Kriterium zu erzeugen. Bei der Beurteilung, ob vorgegebene Bedingungen für das Erzeugen des Ausgangssignals vorliegen, wird somit nicht nur das eigentliche Erfassungssignal, welches lediglich Auskunft über die Anwesenheit eines Objekts, beispielsweise einer Trennvorrichtung oder eines Maschinenteils oder eines an einer Trennvorrichtung oder an einem Maschinenteil angeordneten Aktuators, in dem Überwachungsbereich des Sensors geben kann, berücksichtigt, sondern es werden weitere Parameter, Umgebungsbedingungen oder Sensorsignale herangezogen. Hierfür kann beispielsweise ausgenutzt werden, dass sich die Art und Weise, wie ein Objekt oder Aktuator bei einem Manipulationsversuch in den Überwachungsbereich eingebracht wird, von derjenigen Art und Weise unterscheidet, wie sich der ordnungsgemäße Aktuator in einem Regelbetrieb an den Sensor annähert. Es können beispielsweise Geschwindigkeiten, zeitliche Verläufe, Aufenthaltsdauern oder Wiederholungsfrequenzen berücksichtigt werden, was nachfolgend noch näher erläutert wird. Weiterhin können auch zusätzliche Sensorsignale, die von integrierten oder externen Sensoren der Auswerteeinheit zur Verfügung gestellt werden, berücksichtigt werden. Auch dies wird im Folgenden noch detaillierter ausgeführt.

Das Ausgangssignal kann unmittelbar oder auch zeitverzögert erzeugt werden, wobei zum Beispiel das Erfassungssignal und/oder das zusätzliche Kriterium für eine bestimmte Mindestzeitdauer vorliegen muss.

Die Auswerteeinheit kann als externe Auswerteeinheit vorgesehen sein, mit dem Sensor eine Baueinheit bilden oder mit dem Sensor und anderen nachfolgend noch näher erläuterten zusätzlichen Sensoren in einer Baueinheit integriert sein.

Gemäß einer vorteilhaften Ausführungsform weist die Sicherheitseinrichtung einen Signalausgang zum Ausgeben des Ausgangssignals auf, welcher mit einem Steuereingang der Maschine verbindbar ist. Eine derartige Sicherheitseinrichtung eignet sich insbesondere dafür, gefahrbringende Maschinenfunktionen mit dem Zustand von trennenden Schutzvorrichtungen der Maschine zu verriegeln, so dass ein Fehlen der Schutzvorrichtungen ein Ausführen der gefahrbringenden Funktionen der Maschine verhindert oder unterbricht.

Vorteilhafterweise ist das Ausgangssignal ein Schaltsignal, welches eine Abschaltung der Maschine bewirkt und/oder eine Ingangsetzung der Maschine gestattet. Das Ausgangssignal kann aber auch lediglich ein Warnsignal sein, oder es wird lediglich zu Dokumentationszwecken aufgezeichnet, wenn die Gefährdung von untergeordneter Art ist, was gegebenenfalls durch weitergehende Auswertung des oder der zusätzlichen Kriterien beurteilt werden kann.

Es hat sich als vorteilhaft erwiesen, wenn das Objekt ein dem Sensor zugeordneter Aktuator ist. Hierunter wird beispielsweise ein Gegenstand verstanden, der - entsprechend dem physikalischen Funktionsprinzip des Sensors - definierte induktive, kapazitive, magnetische bzw. optische Eigenschaften aufweist. Somit führt die Anwesenheit eines geeigneten Aktuators, der sich insbesondere innerhalb eines definierten räumlichen Bereichs befinden muss, zum Erzeugen eines Erfassungssignals. Ein Aktuator in diesem Sinne kann auch ein Maschinenteil an sich sein, welches entsprechende, auf den Sensor abgestimmte Eigenschaften aufweist.

Als Aktuator im weiteren Sinne kann auch ein Maschinenteil an sich dienen, welches metallisch ist und daher von dem Sensor detektiert werden kann.

Gemäß einer weiteren vorteilhaften Ausführungsform ist der Aktuator derart codiert, dass der Aktuator dem Sensor zuordenbar ist und/oder der Aktuator durch den Sensor identifizierbar ist. Hierdurch wird die Manipulationssicherheit weiter erhöht. Die Identifizierung kann beispielsweise unmittelbar durch den Sensor oder indirekt durch die Auswerteeinheit erfolgen. Vorzugsweise ist die Zuordnung oder Identifizierung in eindeutiger Weise möglich.

Grundsätzlich kann die vorliegende Erfindung auch bei einer Sicherheitseinrichtung verwirklicht werden, welche nicht zur Erfassung eines Aktuators als Objekt ausgelegt ist, sondern zur Detektion von beliebigen anderen Objekten wie beispielsweise von der Maschine zu bearbeitenden Werkstücken oder in einen Sicherheitsbereich eindringenden Fremdkörpern vorgesehen ist. Insbesondere sind auch solche Sicherheitseinrichtungen umfasst, die die Anwesenheit von Bedienpersonen oder Körperteilen von Bedienpersonen in einem Gefahrenbereich überwachen.

Der Sensor kann aus einer Gruppe von Sensoren ausgewählt sein, welche umfasst:
- einen mechanischen Sensor, welcher dazu ausgelegt ist, einen mechanischen Kontakt mit dem Objekt oder eine durch das Objekt ausgeübte Kraft zu detektieren,
- einen induktiven Sensor, welcher dazu ausgelegt ist, ein ferromagnetisches oder nicht magnetisches leitendes Objekt zu detektieren,
- einen kapazitiven Sensor, welcher dazu ausgelegt ist, ein metallisches oder nichtmetallisches Objekt zu detektieren,
- einen magnetischen Sensor, welcher dazu ausgelegt ist, ein von dem Objekt erzeugtes Magnetfeld zu detektieren,
- einen optischen Sensor, welcher dazu ausgelegt ist, ein von dem Objekt reflektiertes oder remittiertes Licht zu detektieren,
- einen Schallsensor, insbesondere Ultraschallsensor, welcher dazu ausgelegt ist, von dem Objekt reflektierte oder ausgesendete Schallwellen, insbesondere Ultraschallwellen, zu detektieren,
- und einen RFID-Sensor, welcher dazu ausgelegt ist, einen Code zu empfangen, der von einem an dem Objekt angeordneten RFID-Transponder ausgesendet wurde.

Diese Aufzählung von Sensoren, die im Zusammenhang mit der vorliegenden Erfindung eingesetzt werden können, ist nicht abschließend. Es versteht sich, dass bei Sicherheitseinrichtungen, bei denen die Anwesenheit eines Aktuators überwacht werden soll, entsprechend auf den verwendeten Sensortyp abgestimmte Aktuatoren vorgesehen werden, wobei auch denkbar ist, dass solche Aktuatoren verwendet werden können, die aufgrund ihrer Eigenschaften von mehreren Sensoren, die auf unterschiedlichen physikalischen Funktionsprinzipien beruhen, detektiert werden können.

Gemäß einer weiteren vorteilhaften Ausführungsform ist der Sensor ferner dazu ausgelegt, das Erfassungssignal nur dann auszugeben, wenn sich das Objekt in einem definierten Teilbereich des Erfassungsbereichs befindet. Beispielsweise kann der Erfassungsbereich eines insbesondere für eine berührungslose Objektdetektion ausgelegten Sensors in einen Nahbereich und einen Freigabebereich als jeweiliger Teilbereich unterteilt sein, wobei sich z.B. der Nahbereich unmittelbar benachbart zum Sensor befindet und der Freigabebereich sich an den Nahbereich anschließt, so dass ein im Freigabebereich anwesendes Objekt einen größeren Abstand zum Sensor aufweist als ein Objekt im Nahbereich. Der Sensor kann die Anwesenheit eines Objekts in beiden Teilbereichen detektieren, gibt aber nur dann ein Erfassungssignal aus, wenn sich das Objekt im Freigabebereich befindet. So kann etwa bei einer Manipulation durch einen im falschen Abstand, z.B. zu nahe am Sensor angeordneten Aktuator die Ausgabe eines die Maschine freigebenden Ausgangssignals unterbleiben. Hierdurch ist ein weiterer Schutz gegen Manipulation der Sicherheitseinrichtung gegeben.

Bei einer erfindungsgemäßen Ausführungsform ist vorgesehen, dass das zumindest eine zusätzliche Kriterium die Annäherungsgeschwindigkeit des Objekts an den Sensor und/oder den zeitlichen Verlauf der Annäherungsgeschwindigkeit umfasst. Dem liegt der Gedanke zugrunde, dass sich die Geschwindigkeit eines Objekts oder Aktuators, das in einem Regelbetrieb der Sicherungseinrichtung in den Überwachungsbereich gelangt, von derjenigen Geschwindigkeit unterscheidet, mit der es bei einem Manipulationsversuch, der beispielsweise von Hand ausgeführt wird, an den Sensor angenähert wird. Dies kann beispielsweise darauf zurückzuführen sein, dass für ein Fremdobjekt, das anstelle des regulären Aktuators in den Überwachungsbereich gebracht werden soll und zumeist andere physikalische Eigenschaften als der Aktuator aufweist, diejenige Position, an welcher der Sensor ein Erfassungssignal erzeugt, erst durch Probieren herausgefunden werden muss.

Alternativ oder zusätzlich kann das zumindest eine zusätzliche Kriterium die Aufenthaltsdauer des Objekts in dem Überwachungsbereich umfassen. Weiterhin kann eine Wiederholrate von aufeinanderfolgenden Detektionen von Objekten in dem Überwachungsbereich als zusätzliches Kriterium, jeweils für sich oder in Kombination mit einem oder mehreren anderen zusätzlichen Kriterien, herangezogen werden.

Gemäß einer weiteren erfindungsgemäßen Ausführungsform ist die Auswerteeinheit mit zumindest einem Vibrationssensor oder Erschütterungssensor verbunden, welcher dazu ausgelegt ist, durch die abgesicherte Maschine erzeugte Vibrationen oder Erschütterungen zu detektieren, wobei das zumindest eine zusätzliche Kriterium zumindest ein Charakteristikum der detektierten Vibrationen oder Erschütterungen umfasst. Als Charakteristikum kann beispielsweise die Anwesenheit oder Abwesenheit von Vibrationen oder Erschütterungen, deren Amplitude oder Frequenz dienen, wobei das Charakteristikum insbesondere auf einen entsprechenden Schwellenwert bezogen sein kann. Diese Vibrationen oder Erschütterungen können beispielsweise diejenigen Vibrationen oder Erschütterungen sein, die beim Schließen einer Trennvorrichtung an der Maschine entstehen. Denkbar ist auch, dass als Charakteristikum Abweichungen der detektierten Vibrationen von einem Vibrationsmuster, das in einem Regelbetrieb der Maschine entsteht, ermittelt werden können, beispielsweise weil sich das Resonanzverhalten der Maschine durch entfernte Trennvorrichtungen oder Abdeckungen verändert.

Gemäß einer weiteren Ausführungsform kann die Auswerteeinheit alternativ oder zusätzlich mit zumindest einem Umgebungssensor, insbesondere einem Schall-, Druck- oder Temperatursensor, verbunden sein, wobei das zumindest eine zusätzliche Kriterium zumindest ein Charakteristikum eines von dem Umgebungssensor detektierten Messwerts ist.

Gemäß einer weiteren erfindungsgemäßen Ausführungsform ist die Auswerteeinheit dazu ausgelegt, zumindest ein Datenmuster zu erzeugen und zu speichern, welches
i) einen zeitlichen Verlauf des Erfassungssignals und/oder des zusätzlichen Kriteriums für einen Regelbetrieb der Maschine repräsentiert, und/oder
ii) welches einen zeitlichen Verlauf des Erfassungssignals und/oder des zusätzlichen Kriteriums für einen Betrieb der Maschine bei einem Vorliegen von unzulässigen Betriebsbedingungen repräsentiert,
wobei das Ausgangssignal auf der Grundlage eines Vergleichs eines momentanen zeitlichen Verlaufs des Erfassungssignals und/oder des zusätzlichen Kriteriums mit dem gespeicherten Datenmuster erzeugt wird.

Unter einem Regelbetrieb wird ein Betrieb der Maschine ohne manipulierende Eingriffe verstanden, welche geeignet sind, die Sicherheit der Maschine zu beeinträchtigen. Entsprechend wird unter einem Vorliegen von unzulässigen Betriebsbedingungen das Vorliegen von manipulierenden Eingriffen in die Sicherheit der Maschine verstanden, die beispielsweise in einem Entfernen oder Öffnen von Trennvorrichtungen oder Sicherheitsabdeckungen bestehen können. Unter einem momentanen zeitlichen Verlauf des Erfassungssignals bzw. des zusätzlichen Kriteriums wird ein zeitlicher Verlauf innerhalb eines kurzen Betrachtungszeitraums verstanden, welcher beispielsweise auf einen oder wenige Taktzyklen der Maschine beschränkt ist und beispielsweise im Bereich von einigen Millisekunden bis einigen Sekunden liegt.

Es liegt der Gedanke zugrunde, dass jede Maschine (einschließlich der damit verbundenen Sicherheitseinrichtungen und Sensoren) ein maschinenspezifisches Muster erzeugt, wobei dieses Muster Informationen insbesondere über eine Annäherungsgeschwindigkeit eines Aktuators oder Objekts bzw. des zeitlichen Verlaufs dieser Geschwindigkeit, eine Aufenthaltsdauer eines Objekts oder Aktuators in dem Überwachungsbereich, eine Wiederholfrequenz der Erfassung, eine durch zusätzliche Sensoren detektierten Vibrations- oder Erschütterungsbelastung während der Erfassung umfasst. Ein Muster, das diese Maschine unter dem Einfluss von sicherheitsrelevanten Manipulationen erzeugt, wird von diesem Muster abweichen, wobei die Abweichungen nicht zwingend für alle erfassten Parameter vorliegen müssen, sondern auch nur einzelne der vorstehend genannten Kriterien betreffen können. Somit können sowohl für den Regelbetrieb der Maschine als auch für den Betrieb unter unzulässigen Betriebsbedingungen entsprechende "Betriebsmuster" bzw. "Manipulationsmuster" erzeugt werden, die in der Auswerteeinheit in Form einer Bibliothek von Datenmustern gespeichert werden können und fortlaufend mit aktuell erfassten Informationen über das Erfassungssignal und/oder das zumindest eine zusätzliche Kriterium verglichen werden.

Vorteilhafterweise ist die Auswerteeinheit dazu ausgelegt, das Datenmuster im Rahmen eines Einlernvorgangs zu erzeugen. Dies ermöglicht ein Erzeugen unter spezifischen, beispielsweise an den Aufstellraum der Maschine angepassten Bedingungen. Im Rahmen des Einlernvorgangs für ein Betriebsmuster, d.h. ein Datenmuster im Regelbetrieb, muss sichergestellt sein, dass keine die Sicherheit beeinträchtigenden Bedingungen, z.B. offene Abdeckungen, unerlaubte Objekte im Sicherheitsbereich, vorliegen, die das Muster verfälschen könnten. Insbesondere können auch mehrere Einlernvorgänge für unterschiedliche Betriebs- und/oder Manipulationssituationen durchgeführt werden.

Gemäß einer vorteilhaften Abwandlung ist die Auswerteeinheit dazu ausgelegt, das Datenmuster während des fortlaufenden Betriebs der Maschine zu erzeugen, zu erweitern und/oder anzupassen. Hierdurch wird die Sicherheit und Verfügbarkeit der Maschine erhöht, da eine nachträgliche Anpassung an unterschiedliche Betriebsbedingungen möglich wird. Unter einem Erweitern des Datenmusters wird insbesondere verstanden, dass weitere mehr oder weniger voneinander abweichende Muster als zulässig bzw. unzulässig erkannt und zu den bereits gespeicherten Datenmustern hinzugefügt werden können. Unter einem Anpassen wird insbesondere verstanden, dass das oder die gespeicherten Datenmuster kontinuierlich modifiziert werden, um beispielsweise Änderungen im zeitlichen Verlauf des zusätzlichen Kriteriums berücksichtigen zu können, die etwa auf sich ändernde Taktraten der Maschine zurückzuführen sind.

Es hat sich als vorteilhaft erwiesen, wenn die Auswerteeinheit dazu ausgelegt ist, das Datenmuster von einer angeschlossenen externen Speichereinheit auszulesen und/oder an eine angeschlossene externe Speichereinheit auszugeben. Dadurch können Sätze von vielen verschiedenen unterschiedlichen Datenmustern in Form einer Datenbank für zukünftige Verwendungen zugänglich gemacht werden oder erlauben eine Datenanalyse, die das Erkennen von weiteren denkbaren Manipulationsversuchen ermöglicht.

Weitere vorteilhafte Ausführungsformen der Erfindung ergeben sich aus den Unteransprüchen, der Beschreibung und der Zeichnung.

Die vorliegende Erfindung wird nachfolgend anhand eines Ausführungsbeispiels mit Bezug auf die Zeichnung beschrieben. Es zeigen:

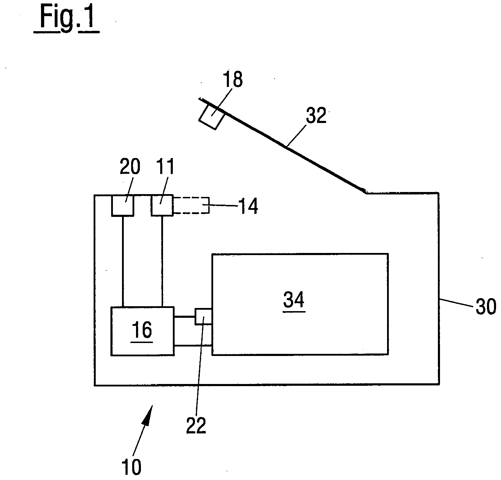

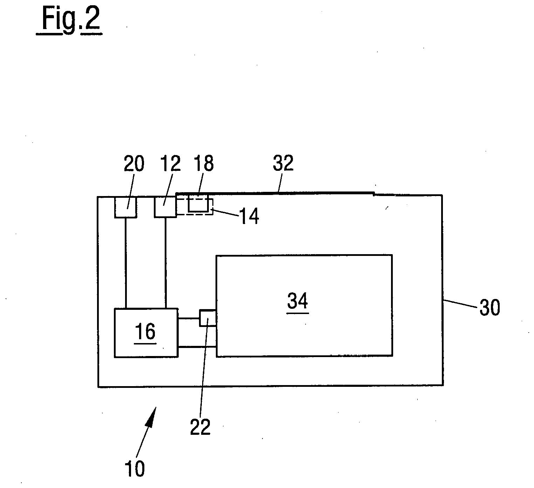

- Fig. 1 und 2: eine erfindungsgemäße Sicherheitseinrichtung, welche an einer zu öffnenden Trennvorrichtung angeordnet ist, welche eine abzusichernde Maschine umgibt.

Fig. 1 und 2 zeigen eine Trennvorrichtung 30 mit einer zu öffnenden Schutzabdeckung 32 in Öffnungsstellung (Fig. 1) und Schließstellung (Fig. 2), welche eine abzusichernde Maschine 34 umgeben, um einen Zugang zu einem Gefahrenbereich der Maschine 34 während eines gefahrbringenden Betriebs zu verhindern.

An der Trennvorrichtung 30 ist eine Sicherheitseinrichtung 10 angeordnet, die einen Sensor 12, welcher dazu ausgelegt ist, die Anwesenheit eines Objekts in Form eines Aktuators 18 in einem Überwachungsbereich 14 zu detektieren, und eine mit dem Sensor 12 verbundene Auswerteeinheit 16 umfasst.

Der Aktuator 18 ist derart an der beweglichen Schutzabdeckung 32 der Trennvorrichtung 30 angeordnet, dass er sich bei geschlossener Schutzabdeckung 32 (Fig. 2) innerhalb des Überwachungsbereichs 14 des Sensors 12 befindet.

Ein Signalausgang der Auswerteeinheit 16 ist mit einem Steuereingang der Maschine 16 verbunden.

Die Sicherheitseinrichtung 10 umfasst im Ausführungsbeispiel ferner zwei Vibrationssensoren 20, 22 oder Erschütterungssensoren, wobei der Vibrationssensor 20 nahe des Sensors 12 angeordnet ist und dazu ausgelegt ist, Vibrationen, die beim Schließen der Schutzabdeckung 32 auftreten, zu detektieren. Der Vibrationssensor 22 ist an der Maschine 34 angeordnet und dazu ausgelegt, während des Betriebs der Maschine 34 auftretende Vibrationen oder Erschütterungen zu detektieren. Bei Abwandlungen können auch nur einer der Vibrationssensoren 20, 22 oder aber auch weitere Vibrations- oder Erschütterungssensoren vorgesehen sein. Bei weiteren Abwandlungen können alternativ oder zusätzlich auch andere Umgebungssensoren, wie z.B. Schall-, Druck- oder Temperatursensoren vorgesehen sein. Gemäß noch weiterer Abwandlungen können alle oder ein Teil der Vibrations- oder Erschütterungssensoren und/oder anderen Umgebungssensoren baulich in den Sensor 12 integriert sein.

Der Sensor 12 kann als induktiver Sensor ausgebildet sein und der Aktuator 18 entsprechend aus einem ferromagnetischen Material gefertigt sein, so dass der Sensor 12 bei geschlossener Schutzabdeckung 32 die Anwesenheit des Aktuators 18 in dem Überwachungsbereich 14 feststellen kann und ein entsprechendes Erfassungssignal an die Auswerteeinheit 16 übermitteln kann.

Die Auswerteeinheit 16 ist dazu ausgelegt, in Abhängigkeit von dem Erfassungssignal ein Ausgangssignal zu erzeugen und an die Maschine 34 zu übermitteln. Beispielsweise kann das Ausgangssignal darin bestehen, dass ein Schaltkontakt geschlossen wird, welcher nur in dieser Schließposition zulässt, die Maschine 34 in Gang zu setzen. Wenn der Schaltkontakt geöffnet ist oder wird, ist das Ingangsetzen der Maschine 34 nicht möglich bzw. wird die laufende Maschine 34 abgeschaltet.

Die Auswerteeinheit 16 erzeugt nur dann ein Ausgangssignal, das den Betrieb der Maschine gestattet, wenn der Sensor 12 aufgrund der Anwesenheit des Aktuators 18 in dem Überwachungsbereich 14, d.h. bei geschlossener Schutzabdeckung 32 (Fig. 2), das Erfassungssignal erzeugt und ferner ein oder mehrere zusätzliche Kriterien erfüllt sind.

Beispielsweise kann der Sensor 12 dazu ausgelegt sein, das Maß einer durch die Anwesenheit des Aktuators 18 oder eines fremden, zu Manipulationszwecken eingebrachten Objekts bewirkten Veränderung des von dem Sensor 12 erzeugten Magnetfeldes zu ermitteln. So kann beispielsweise unterschieden werden, ob sich tatsächlich der zugeordnete Aktuator 18 in dem Überwachungsbereich 14 befindet oder ob lediglich ein anderer geeigneter ferromagnetischer Gegenstand, beispielsweise eine Münze, in den Überwachungsbereich 14 eingebracht wurde, um bei geöffneter Schutzabdeckung 32 in manipulativer Absicht ein Ingangsetzen der Maschine 34 vornehmen zu können.

Als weiteres zusätzliches Kriterium kann die Geschwindigkeit bzw. eine davon abgeleitete Größe herangezogen werden, mit welcher der Aktuator 18 (bzw. ein manipulativer Gegenstand) in den Überwachungsbereich 14 eingebracht wird. Die Geschwindigkeit oder auch ein Geschwindigkeitsverlauf kann beispielsweise dadurch ermittelt werden, dass die zeitliche Veränderung des von dem Sensor 12 erzeugten Magnetfeldes gemessen wird. Dem liegt der Gedanke zugrunde, dass der Aktuator 18 typischerweise mit einem charakteristischen Geschwindigkeitsverlauf in den Überwachungsbereich eintritt, wenn die Schutzabdeckung 32 geschlossen wird. Dieser Verlauf lässt sich durch ein Einbringen eines manipulativen Gegenstandes nur schwer nachahmen.

Zusätzlich oder alternativ könnte auch ein von dem Vibrationssensor 20 erzeugtes weiteres Sensorsignal herangezogen werden, welches beim Schließen der Schutzabdeckung 32 durch Anschlagen an dem feststehenden Teil der Trennvorrichtung 30 entsteht. Auch dieses typische, durch das Zuschlagen der Schutzabdeckung 32 entstehende Vibrationsmuster lässt sich nur sehr schwer und vor allem nicht mit der erforderlichen zeitlichen Koinzidenz zu dem vom Sensor 12 erzeugten Erfassungssignal simulieren.

Auch von dem an der Maschine 34 angeordneten Vibrationssensor 22 erzeugte Vibrationen, die auf einen Betrieb der Maschine zurückzuführen sind, können für die Erzeugung des Ausgangssignals durch die Auswerteeinheit 16 herangezogen werden. Dies kann beispielsweise in einer Form erfolgen, dass der Betrieb der Maschine 34 mit einer sehr niedrigen Arbeitsgeschwindigkeit, beispielsweise zu Einrichtungszwecken, auch bei geöffneter Schutzabdeckung 32 toleriert werden kann, jedoch höhere Taktraten der Maschine 34, die auch eine erhöhte Gefährdung von Bedienpersonen mit sich bringen, bei geöffneter Schutzabdeckung 32 zum Erzeugen eines die Maschine 34 stoppenden Ausgangssignals führen.

Gemäß einer weiteren Abwandlung können die von dem Sensor 12 und/oder den Vibrationssensoren 20, 22 erzeugten Signale und/oder andere zusätzliche Kriterien bzw. deren zeitlichen Verläufe und/oder Wiederholraten von der Auswerteeinheit 16 erfasst werden und in Form von Datenmustern in der Auswerteeinheit 16 gespeichert werden, wie dies bereits vorstehend näher erläutert wurde. Derartige Datenmuster können für einen Regelbetrieb der Maschine 34 ohne manipulierende Eingriffe und/oder für einen Betrieb unter manipulativen Bedingungen erzeugt und gespeichert werden. Die den Datenmustern zugrundeliegenden Daten werden während des Betriebs der Sicherheitseinrichtung 10 bzw. der Maschine 34 fortlaufend ermittelt und mit den gespeicherten Datenmustern verglichen. Ein Anpassen der Datenmuster an sich ändernde Betriebsbedingungen oder auch ein Erweitern durch Hinzufügen von zusätzlichen Datenmustern kann vorgesehen sein.

### Bezugszeichenliste

- 10: Sicherheitseinrichtung
- 12: Sensor
- 14: Überwachungsbereich
- 16: Auswerteeinheit
- 18: Aktuator
- 20, 22: Vibrationssensor
- 30: Trennvorrichtung
- 32: Schutzabdeckung
- 34: Maschine

## Patentansprüche

1. Sicherheitseinrichtung (10) zum Absichern einer Maschine (34), mit einem Sensor (12), welcher dazu ausgelegt ist, die Anwesenheit eines Objekts in einem Überwachungsbereich (14) zu detektieren und ein Erfassungssignal auszugeben, wenn sich das Objekt in dem Überwachungsbereich (14) befindet, und
einer Auswerteeinheit (16), welche dazu ausgelegt ist, das Erfassungssignal von dem Sensor (12) zu empfangen und ein Ausgangssignal in Abhängigkeit von dem Erfassungssignal zu erzeugen,
wobei die Auswerteeinheit (16) dazu ausgelegt ist, das Ausgangssignal ferner in Abhängigkeit von zumindest einem zusätzlichen Kriterium zu erzeugen,
**dadurch gekennzeichnet,**
**dass** das zumindest eine zusätzliche Kriterium die Annäherungsgeschwindigkeit des Objekts an den Sensor (12) und/oder den zeitlichen Verlauf der Annäherungsgeschwindigkeit umfasst, und/oder
**dass** das zumindest eine zusätzliche Kriterium die Aufenthaltsdauer des Objekts in dem Überwachungsbereich (14) umfasst, und/oder
**dass** das zumindest eine zusätzliche Kriterium eine Wiederholrate von aufeinanderfolgenden Detektionen von Objekten in dem Überwachungsbereich (14) umfasst, und/oder
**dass** die Auswerteeinheit (16) mit zumindest einem Vibrationssensor (20, 22) oder Erschütterungssensor verbunden ist, welcher dazu ausgelegt ist, durch den Betrieb der abgesicherten Maschine (34) erzeugte Vibrationen oder Erschütterungen zu detektieren, wobei das zumindest eine zusätzliche Kriterium zumindest ein Charakteristikum der detektierten Vibrationen oder Erschütterungen umfasst, und/oder
**dass** die Auswerteeinheit (16) dazu ausgelegt ist, zumindest ein Datenmuster zu erzeugen und zu speichern, welches
i) einen zeitlichen Verlauf des Erfassungssignals und/oder des zusätzlichen Kriteriums für einen Regelbetrieb der Maschine (34) repräsentiert, und/oder
ii) welches einen zeitlichen Verlauf des Erfassungssignals und/oder des zusätzlichen Kriteriums für einen Betrieb der Maschine (34) bei einem Vorliegen von unzulässigen Betriebsbedingen repräsentiert, wobei das Ausgangsignal auf der Grundlage eines Vergleichs eines momentanen zeitlichen Verlaufs des Erfassungssignals und/oder des zusätzlichen Kriteriums mit dem gespeicherten Datenmuster erzeugt wird.

2. Sicherheitseinrichtung (10) nach Anspruch 1,
**dadurch gekennzeichnet,**
**dass** die Sicherheitseinrichtung (10) einen Signalausgang zum Ausgeben des Ausgangssignals aufweist, welcher mit einem Steuereingang der Maschine (34) verbindbar ist.

3. Sicherheitseinrichtung (10) nach Anspruch 1 oder 2,
**dadurch gekennzeichnet,**
**dass** das Ausgangssignal ein Schaltsignal ist, welches eine Abschaltung der Maschine (34) bewirkt und/oder eine Ingangsetzung der Maschine (34) gestattet.

4. Sicherheitseinrichtung (10) nach einem der vorhergehenden Ansprüche,
**dadurch gekennzeichnet,**
**dass** das Objekt ein dem Sensor (12) zugeordneter Aktuator (18) ist.

5. Sicherheitseinrichtung (10) nach Anspruch 4,
**dadurch gekennzeichnet,**
**dass** der Aktuator (18) derart codiert ist, dass der Aktuator (18) dem Sensor (12) zuordenbar ist und/oder der Aktuator (18) durch den Sensor (12) identifizierbar ist.

6. Sicherheitseinrichtung (10) nach einem der vorhergehenden Ansprüche,
**dadurch gekennzeichnet,**
**dass** der Sensor (12) aus einer Gruppe von Sensoren ausgewählt ist, welche umfasst:
- einen mechanischen Sensor, welcher dazu ausgelegt ist, einen mechanischen Kontakt mit dem Objekt oder eine durch das Objekt ausgeübte Kraft zu detektieren,
- einen induktiven Sensor, welcher dazu ausgelegt ist, ein ferromagnetisches oder nichtmagnetisches leitendes Objekt zu detektieren,
- einen kapazitiven Sensor, welcher dazu ausgelegt ist, ein metallisches oder nicht metallisches Objekt zu detektieren,
- einen magnetischen Sensor, welcher dazu ausgelegt ist, ein von dem Objekt erzeugtes Magnetfeld zu detektieren,
- einen optischen Sensor, welcher dazu ausgelegt ist, ein von dem Objekt reflektiertes oder remittiertes Licht zu detektieren,
- einen Schallsensor, insbesondere Ultraschallsensor, welcher dazu ausgelegt ist, von dem Objekt reflektierte oder ausgesendete Schallwellen, insbesondere Ultraschallwellen, zu detektieren, und
- einen RFID-Sensor, welcher dazu ausgelegt ist, einen Code zu empfangen, der von einem an dem Objekt angeordneten RFID-Transponder ausgesendet wurde.

7. Sicherheitseinrichtung (10) nach einem der vorhergehenden Ansprüche,
**dadurch gekennzeichnet,**
**dass** die Auswerteeinheit (16) dazu ausgelegt ist, zumindest ein Datenmuster zu erzeugen und zu speichern, welches
i) einen zeitlichen Verlauf des Erfassungssignals und/oder des zusätzlichen Kriteriums für einen Regelbetrieb der Maschine (34) repräsentiert, und/oder
ii) welches einen zeitlichen Verlauf des Erfassungssignals und/oder des zusätzlichen Kriteriums für einen Betrieb der Maschine (34) bei einem Vorliegen von unzulässigen Betriebsbedingen repräsentiert,
wobei das Ausgangsignal auf der Grundlage eines Vergleichs eines momentanen zeitlichen Verlaufs des Erfassungssignals und/oder des zusätzlichen Kriteriums mit dem gespeicherten Datenmuster erzeugt wird, und dass die Auswerteeinheit (16) dazu ausgelegt ist, das Datenmuster im Rahmen eines Einlernvorgangs zu erzeugen.

8. Sicherheitseinrichtung (10) nach einem der vorhergehenden Ansprüche"
**dadurch gekennzeichnet,**
**dass** die Auswerteeinheit (16) dazu ausgelegt ist, zumindest ein Datenmuster zu erzeugen und zu speichern, welches
i) einen zeitlichen Verlauf des Erfassungssignals und/oder des zusätzlichen Kriteriums für einen Regelbetrieb der Maschine (34) repräsentiert, und/oder
ii) welches einen zeitlichen Verlauf des Erfassungssignals und/oder des zusätzlichen Kriteriums für einen Betrieb der Maschine (34) bei einem Vorliegen von unzulässigen Betriebsbedingen repräsentiert,
wobei das Ausgangsignal auf der Grundlage eines Vergleichs eines momentanen zeitlichen Verlaufs des Erfassungssignals und/oder des zusätzlichen Kriteriums mit dem gespeicherten Datenmuster erzeugt wird, und dass die Auswerteeinheit (16) dazu ausgelegt ist, das Datenmuster während des fortlaufenden Betriebs der Maschine (34) zu erzeugen, zu erweitern und/oder anzupassen.

9. Sicherheitseinrichtung (10) nach einem der vorhergehenden Ansprüche,
**dadurch gekennzeichnet,**
**dass** die Auswerteeinheit (16) dazu ausgelegt ist, zumindest ein Datenmuster zu erzeugen und zu speichern, welches
i) einen zeitlichen Verlauf des Erfassungssignals und/oder des zusätzlichen Kriteriums für einen Regelbetrieb der Maschine (34) repräsentiert, und/oder
ii) welches einen zeitlichen Verlauf des Erfassungssignals und/oder des zusätzlichen Kriteriums für einen Betrieb der Maschine (34) bei einem Vorliegen von unzulässigen Betriebsbedingen repräsentiert,
wobei das Ausgangsignal auf der Grundlage eines Vergleichs eines momentanen zeitlichen Verlaufs des Erfassungssignals und/oder des zusätzlichen Kriteriums mit dem gespeicherten Datenmuster erzeugt wird, und dass die Auswerteeinheit (16) dazu ausgelegt ist, das Datenmuster von einer angeschlossenen externen Speichereinheit auszulesen und/oder an eine angeschlossene externe Speichereinheit auszugeben.

## Claims

1. A safety device (10) for securing a machine (34) having
a sensor (12) which is adapted to detect the presence of an object in a monitored zone (14) and to output a detection signal when the object is located in the monitored zone (14); and
having an evaluation unit (16) which is adapted to receive the detection signal from the sensor (12) and to generate an output signal in dependence on the detection signal,
wherein the evaluation unit (16) is adapted to furthermore generate the output signal in dependence on at least one additional criterion, **characterized in that**
the at least one additional criterion comprises the approach speed of the object to the sensor (12) and/or the temporal progression of the approach speed; and/or
**in that** the at least one additional criterion comprises the dwell time of the object in the monitored zone (14); and/or
**in that** the at least one additional criterion comprises a repetition rate of sequential detections of objects in the monitored zone (14); and/or
**in that** the evaluation unit (16) is connected to at least one vibration sensor (20, 22) or tremor sensor which is adapted to detect vibrations or tremors generated by the operation of the secured machine (34), with the at least one additional criterion comprising at least one characteristic of the detected vibrations or tremors; and/or
**in that**
the evaluation unit (16) is adapted to generate and to store at least one data pattern which
i) represents a temporal progression of the detection signal and/or of the additional criterion for a regular operation of the machine (34); and/or
ii) which represents a temporal progression of the detection signal and/or of the additional criterion for an operation of the machine (34) on a presence of non-permitted operating conditions,
with the output signal being generated on the basis of a comparison of an instantaneous temporal progression of the detection signal and/or of the additional criterion with the stored data pattern.

2. A safety device (10) in accordance with claim 1,
**characterized in that**
the safety device (10) has a signal output for outputting the output signal which is connectable to a control input of the machine (34).

3. A safety device (10) in accordance with claim 1 or claim 2,
**characterized in that**
the output signal is a switching signal which effects a switching off of the machine (34) and/or allows a putting into operation of the machine (34).

4. A safety device (10) in accordance with any one of the preceding claims,
**characterized in that**
the object is an actuator (18) associated with the sensor (12).

5. A safety device (10) in accordance with claim 4,
**characterized in that**
the actuator (18) is coded such that the actuator (18) can be associated with the sensor (12) and/or such that the actuator (18) can be identified by the sensor (12).

6. A safety device (10) in accordance with any one of the preceding claims,
**characterized in that**
the sensor (12) is selected from a group of sensors, said group comprising:
- a mechanical sensor which is adapted to detect a mechanical contact with the object or a force exerted by the object;
- an inductive sensor which is adapted to detect a ferromagnetic or non-magnetic conductive object;
- a capacitive sensor which is adapted to detect a metallic or non-metallic object;
- a magnetic sensor which is adapted to detect a magnetic field generated by the object;
- an optical sensor which is adapted to detect light reflected or remitted by the object;
- a sound sensor, in particular an ultrasound sensor, which is adapted to detect sound waves, in particular ultrasound waves, reflected or transmitted by the object; and
- an RFID sensor which is adapted to receive a code which was transmitted by an RFID transponder arranged at the object.

7. A safety device (10) in accordance with any one of the preceding claims,
**characterized in that**
the evaluation unit (16) is adapted to generate and to store at least one data pattern which
i) represents a temporal progression of the detection signal and/or of the additional criterion for a regular operation of the machine (34); and/or
ii) which represents a temporal progression of the detection signal and/or of the additional criterion for an operation of the machine (34) on a presence of non-permitted operating conditions,
with the output signal being generated on the basis of a comparison of an instantaneous temporal progression of the detection signal and/or of the additional criterion with the stored data pattern; and **in that** the evaluation unit (16) is adapted to generate the data pattern as part of a teaching process.

8. A safety device (10) in accordance with any one of the preceding claims, **characterized in that**
the evaluation unit (16) is adapted to generate and to store at least one data pattern which
i) represents a temporal progression of the detection signal and/or of the additional criterion for a regular operation of the machine (34); and/or
ii) which represents a temporal progression of the detection signal and/or of the additional criterion for an operation of the machine (34) on a presence of non-permitted operating conditions,
with the output signal being generated on the basis of a comparison of an instantaneous temporal progression of the detection signal and/or of the additional criterion with the stored data pattern; and **in that** the evaluation unit (16) is adapted to generate, to expand and/or to adjust the data pattern during the continuous operation of the machine (34).

9. A safety device (10) in accordance with any one of the preceding claims, **characterized in that**
the evaluation unit (16) is adapted to generate and to store at least one data pattern which
i) represents a temporal progression of the detection signal and/or of the additional criterion for a regular operation of the machine (34); and/or
ii) which represents a temporal progression of the detection signal and/or of the additional criterion for an operation of the machine (34) on a presence of non-permitted operating conditions,
with the output signal being generated on the basis of a comparison of an instantaneous temporal progression of the detection signal and/or of the additional criterion with the stored data pattern; and **in that** the evaluation unit (16) is adapted to read the data pattern from a connected external storage unit and/or to output it to a connected external storage unit.

## Revendications

1. Dispositif de sécurité (10) pour sécuriser une machine (34), comportant
un capteur (12) conçu pour détecter la présence d'un objet dans une zone à surveiller (14) et pour émettre un signal de détection lorsque l'objet se trouve dans la zone à surveiller (14), et
une unité d'évaluation (16) conçue pour recevoir le signal de détection du capteur (12) et pour générer un signal de sortie en fonction du signal de détection,
l'unité d'évaluation (16) étant conçue pour générer le signal de sortie en outre en fonction d'au moins un critère supplémentaire,
**caractérisé en ce que**
ledit au moins un critère supplémentaire inclut la vitesse d'approche de l'objet vers le capteur (12) et/ou le déroulement temporel de la vitesse d'approche, et/ou
ledit au moins un critère supplémentaire inclut la durée de séjour de l'objet dans la zone à surveiller (14), et/ou
ledit au moins un critère supplémentaire inclut un taux de répétition de détections successives d'objets dans la zone à surveiller (14), et/ou **en ce que** l'unité d'évaluation (16) est connectée à au moins un capteur de vibrations (20, 22) ou à un capteur de secousses qui est conçu pour détecter des vibrations ou des secousses générées par le fonctionnement de la machine sécurisée (34), ledit au moins un critère supplémentaire incluant au moins une caractéristique des vibrations ou secousses détectées, et/ou **en ce que** l'unité d'évaluation (16) est conçue pour générer et mémoriser au moins un schéma de données qui représente
i) un déroulement temporel du signal de détection et/ou du critère supplémentaire pour un fonctionnement régulier de la machine (34), et/ou
ii) un déroulement temporel du signal de détection et/ou du critère supplémentaire pour un fonctionnement de la machine (34) en présence de conditions de fonctionnement inadmissibles,
le signal de sortie étant généré en se basant sur une comparaison d'un déroulement temporel momentané du signal de détection et/ou du critère supplémentaire au schéma de données mémorisé.

2. Dispositif de sécurité (10) selon la revendication 1,
**caractérisé en ce que**
le dispositif de sécurité (10) présente une sortie de signal pour émettre le signal de sortie, qui est susceptible d'être connectée à une entrée de commande de la machine (34).

3. Dispositif de sécurité (10) selon la revendication 1 ou 2,
**caractérisé en ce que**
le signal de sortie est un signal de commutation qui provoque un arrêt de la machine (34) et/ou qui permet une mise en route de la machine (34).

4. Dispositif de sécurité (10) selon l'une des revendications précédentes,
**caractérisé en ce que**
l'objet est un actuateur (18) associé au capteur (12).

5. Dispositif de sécurité (10) selon la revendication 4,
**caractérisé en ce que**
l'actuateur (18) est codé de telle sorte que l'actuateur (18) est susceptible d'être associé au capteur (12) et/ou l'actuateur (18) est identifiable par le capteur (12).

6. Dispositif de sécurité (10) selon l'une des revendications précédentes,
**caractérisé en ce que**
le capteur (12) est choisi parmi un groupe de capteurs comprenant :
- un capteur mécanique conçu pour détecter un contact mécanique avec l'objet ou une force exercée par l'objet,
- un capteur inductif conçu pour détecter un objet conducteur ferromagnétique ou non-magnétique,
- un capteur capacitif conçu pour détecter un objet métallique ou non-métallique,
- un capteur magnétique conçu pour détecter un champ magnétique généré par l'objet,
- un capteur optique conçu pour détecter une lumière réfléchie ou réémise par l'objet,
- un capteur sonore, en particulier un capteur ultrasonore, conçu pour détecter des ondes sonores, en particulier des ondes ultrasonores, réfléchies ou émises par l'objet, et
- un capteur RFID conçu pour recevoir un code émis par un transpondeur RFID agencé sur l'objet.

7. Dispositif de sécurité (10) selon l'une des revendications précédentes,
**caractérisé en ce que**
l'unité d'évaluation (16) est conçue pour générer et mémoriser au moins un schéma de données qui représente
i) un déroulement temporel du signal de détection et/ou du critère supplémentaire pour un fonctionnement régulier de la machine (34), et/ou
ii) un déroulement temporel du signal de détection et/ou du critère supplémentaire pour un fonctionnement de la machine (34) en présence de conditions de fonctionnement inadmissibles,
le signal de sortie étant généré en se basant sur une comparaison d'un déroulement temporel momentané du signal de détection et/ou du critère supplémentaire au schéma de données mémorisé, et **en ce que** l'unité d'évaluation (16) est conçue pour générer le schéma de données dans le cadre d'une opération d'apprentissage.

8. Dispositif de sécurité (10) selon l'une des revendications précédentes,
**caractérisé en ce que**
l'unité d'évaluation (16) est conçue pour générer et mémoriser au moins un schéma de données qui représente
i) un déroulement temporel du signal de détection et/ou du critère supplémentaire pour un fonctionnement régulier de la machine (34), et/ou
ii) un déroulement temporel du signal de détection et/ou du critère supplémentaire pour un fonctionnement de la machine (34) en présence de conditions de fonctionnement inadmissibles,
le signal de sortie étant généré en se basant sur une comparaison d'un déroulement temporel momentané du signal de détection et/ou du critère supplémentaire au schéma de données mémorisé, et **en ce que** l'unité d'évaluation (16) est conçue pour générer, élargir et/ou adapter le schéma de données pendant le fonctionnement en cours de la machine (34).

9. Dispositif de sécurité (10) selon l'une des revendications précédentes,
**caractérisé en ce que**
l'unité d'évaluation (16) est conçue pour générer et mémoriser au moins un schéma de données qui représente
i) un déroulement temporel du signal de détection et/ou du critère supplémentaire pour un fonctionnement régulier de la machine (34), et/ou
ii) un déroulement temporel du signal de détection et/ou du critère supplémentaire pour un fonctionnement de la machine (34) en présence de conditions de fonctionnement inadmissibles,
le signal de sortie étant généré en se basant sur une comparaison d'un déroulement temporel momentané du signal de détection et/ou du critère supplémentaire au schéma de données mémorisé, et **en ce que** l'unité d'évaluation (16) est conçue pour lire le schéma de données d'une unité de mémorisation externe branchée et/ou pour l'émettre à une unité de mémorisation externe branchée.
